# FASCICULE DE BREVET EUROPEEN

(11) **EP 2 782 156 B1**
(45) Date de publication et mention de la délivrance du brevet: **24.04.2019**
(21) Numéro de dépôt: 14160515.4
(22) Date de dépôt: 18.03.2014
(51) Int. Cl.: H01L 51/52, H01L 51/44, H01L 51/10, H01L 27/32

(54) **Procédé d'encapsulation et dispositif associé**
Einkapselungsverfahren und entsprechende Vorrichtung
Encapsulation method and related device

(30) Priorité: 21.03.2013 FR 1352533
(43) Date de publication de la demande: 24.09.2014
(73) Titulaire: Commissariat à l'Énergie Atomique et aux Énergies Alternatives, 75015 Paris (FR)
(72) Inventeur: Maindron, Tony, 38000 Grenoble (FR); Troc, Nicolas, 69100 Villeurbanne (FR)
(74) Mandataire: Audier, Philippe André

(56) Documents cités:
- EP-A1- 0 899 987
- JP-A- 2002 373 777
- JP-A- 2003 208 975
- US-A1- 2003 143 319
- US-A1- 2011 049 591
- US-B1- 6 552 488

## Description

### DOMAINE TECHNIQUE

La présente invention concerne le domaine de l'encapsulation de composants électroniques, notamment de composants opto-électroniques. L'invention concerne également le domaine des dispositifs électroniques comprenant un tel composant.

### ÉTAT DE LA TECHNIQUE ANTÉRIEURE

Certains composants électroniques nécessitent pour leur bon fonctionnement d'être maintenus sous atmosphère contrôlée. Il s'agit par exemple de composants opto-électroniques tels que des diodes électroluminescentes organiques dites OLED (pour l'anglais « *Organic Light-Emitting Diode* »). A cette fin, ces composants sont enfermés, ou encapsulés, de manière hermétique à l'intérieur d'une cavité dont l'atmosphère est contrôlée (contrôle notamment de la nature du gaz et de la pression régnant dans la cavité).

Le composant est classiquement réalisé par dépôt de couches sur un support (ou substrat) et est recouvert d'un capot. Le capot forme, avec le substrat, la cavité hermétique souhaitée. Ce capot est parfois appelé « structure d'encapsulation ». Il est généralement réalisé par dépôt d'au moins une couche mince, dite couche d'encapsulation, recouvrant et enveloppant latéralement le composant.

Le composant est relié à au moins une piste de contact électrique conductrice d'électricité, qui permet l'alimentation électrique du composant, l'utilisation de signaux que ledit composant est appelé à générer, ou encore le pilotage de fonctions qu'il incorpore. La piste de contact électrique est typiquement formée sur le substrat. Une piste de contact électrique s'étend typiquement entièrement et directement sur le substrat.

Les couches d'encapsulation sont des isolants électriques.

Lors de l'encapsulation du composant se pose donc la question de savoir comment préserver les pistes de contact électrique, pour éviter qu'elles ne soient recouvertes par une couche d'encapsulation.

La difficulté provient du fait que les techniques usuelles d'encapsulation n'autorisent pas un dépôt d'une couche d'encapsulation de façon localisée. Ainsi, les pistes de contact électrique se trouvent recouvertes par la couche d'encapsulation.

C'est notamment le cas lors d'un dépôt chimique en phase vapeur dit dépôt CVD (pour l'anglais « *Chemical Vapor Deposition* »), en particulier un dépôt PECVD (pour « *Plasma Enhanced CVD* ») ou un dépôt ALD (pour l'anglais « *Atomic Layer Deposition* »). Un dépôt CVD désigne une méthode de dépôt sous vide de films minces, à partir de précurseurs gazeux. Un dépôt CVD présente l'avantage de préserver l'intégrité de composants fragiles, notamment des composants organiques. Il est donc préféré à d'autres techniques de dépôt, comme le dépôt PVD (pour l'anglais « *Physical Vapor Deposition* ») autorisant éventuellement un dépôt localisé mais détériorant le composant à encapsuler.

On connaît dans l'art antérieur différentes techniques pour préserver les pistes de contact électrique.

On connaît par exemple des procédés pour éliminer localement la couche d'encapsulation, de façon à découvrir les pistes de contact électrique. Un tel procédé est décrit dans le document US 2006/0051951, qui propose une ablation par exposition à un rayonnement laser. Pour que l'ablation soit efficace, ce document propose un empilement particulier de couches au-dessus des pistes de contact électrique, ce qui rend le procédé particulièrement long et complexe.

On connaît également dans l'art antérieur la demande de brevet US 2003/0143319 A1, qui décrit notamment un dispositif OLED encapsulé sous une couche d'encapsulation en oxyde d'aluminium, avec une couche métallique de protection disposée entre la cathode et la couche d'encapsulation.

Dans la demande de brevet EP 0 899 987 A1, il est enseigné notamment que le nitrure d'aluminium, entre autres exemples, offre une bonne protection à l'égard de l'humidité.

Un objectif de la présente invention est de proposer un procédé d'encapsulation et un dispositif électronique, permettant de connecter électriquement un composant encapsulé et qui ne présente pas au moins l'un des inconvénients de l'art antérieur.

En particulier, un objectif de la présente invention est de proposer un procédé simple et efficace, permettant de connecter électriquement un composant encapsulé.

### EXPOSÉ DE L'INVENTION

La présente invention est définie par un procédé d'encapsulation énoncé en revendication 1.

Selon l'invention, on dépose donc la couche de nitrure de titane directement sur au moins une partie de la piste de contact électrique, puis on dépose la couche d'encapsulation notamment sur la couche de nitrure de titane. La portion de couche d'encapsulation déposée sur la couche de nitrure de titane est déposée directement sur celle-ci.

Avantageusement, la couche d'encapsulation est en contact direct avec la couche de nitrure de titane, dans toute la zone située au-dessus de la piste de contact électrique. De la même façon, la couche de nitrure de titane est avantageusement en contact direct avec la piste de contact électrique, sur toute la surface de celle-ci.

La couche de nitrure de titane peut être entièrement recouverte par une portion de la couche d'encapsulation.

Le dépôt de la couche de nitrure de titane sur au moins une partie de la piste de contact électrique peut être réalisé par dépôt physique en phase vapeur.

Avantageusement, le dépôt de la couche de nitrure de titane sur au moins une partie de la piste de contact électrique est réalisé au cours d'une étape de fabrication du composant, le composant étant fabriqué par dépôts successifs de couches dont l'une au moins est une couche de nitrure de titane.

Le procédé selon l'invention comprend notamment une étape de reprise de contact électrique avec l'au moins une partie de la piste de contact électrique, à l'aide d'un élément de contact électrique déposé sur le dessus de la couche d'encapsulation. L'élément de contact électrique est par exemple une pointe ou un fil de contact, déposé sur la couche d'encapsulation. On réalise ainsi un contact électrique entre la piste de contact électrique et l'élément de contact électrique (connecté à une source d'énergie électrique), au travers de la couche de nitrure de titane et la couche d'encapsulation.

L'invention concerne également un dispositif électronique tel que défini en revendication 4.

Selon l'invention, la couche d'encapsulation est donc déposée notamment sur la couche de nitrure de titane, et la couche de nitrure de titane est déposée directement sur l'au moins une partie de la piste de contact électrique. La portion de couche d'encapsulation déposée sur la couche de nitrure de titane est déposée directement sur celle-ci.

La couche d'encapsulation peut former une surface externe du dispositif. En particulier, la couche d'encapsulation peut former une surface externe du dispositif, dans la zone située au-dessus de la piste de contact électrique.

De préférence, la couche de métal est une couche d'un alliage aluminium et cuivre.

Alternativement, la couche de métal peut être une couche de cuivre ou une couche d'aluminium ou une couche de chrome.

La couche d'encapsulation présente avantageusement une épaisseur comprise entre 20 nm et 200 nm.

La couche de nitrure de titane présente avantageusement une épaisseur comprise entre 5 nm et 250 nm.

Le composant peut être une cellule solaire inorganique, une OLED, un OPV, ou un composant micro-électronique tel qu'un transistor.

### BRÈVE DESCRIPTION DES DESSINS

La présente invention sera mieux comprise à la lecture de la description d'exemples de réalisation donnés à titre purement indicatif et nullement limitatif, en faisant référence aux dessins annexés parmi lesquels :
- la figure 1 illustre le principe à la base de l'invention ;
- la figure 2 illustre un premier mode de réalisation d'une partie d'un dispositif électronique selon l'invention ;
- la figure 3 illustre un deuxième mode de réalisation d'une partie d'un dispositif électronique selon l'invention ; et
- la figure 4 illustre un troisième mode de réalisation d'une partie d'un dispositif électronique selon l'invention.

### EXPOSÉ DÉTAILLÉ DE MODES DE RÉALISATION PARTICULIERS

L'idée à la base de l'invention est d'exploiter la mise en évidence de la conduction électrique d'un empilement particulier de couches.

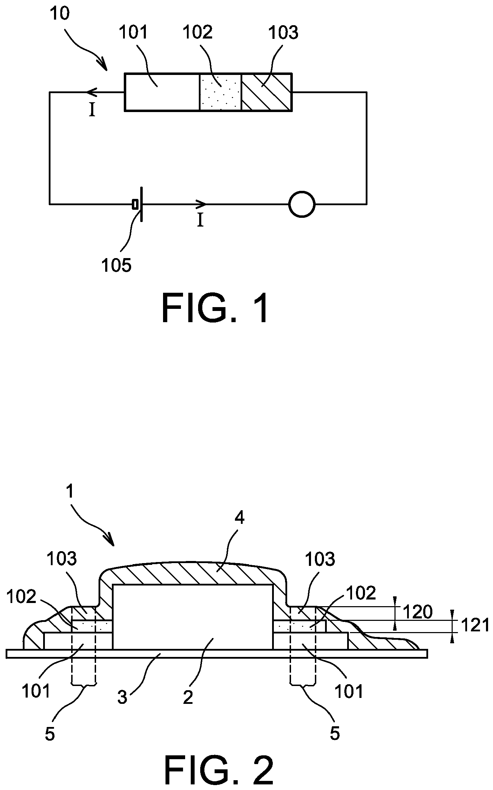

Cette propriété est illustrée de façon schématique à la figure 1, représentant un empilement 10 soumis à une tension électrique par un générateur 105.

L'empilement 10 comprend :
- une couche de métal 101 ;
- une couche de nitrure de titane (TiN) 102, déposée sur la couche de métal 101; et
- une couche d'oxyde d'aluminium (Al₂O₃) 103 déposée par un dépôt de couches minces atomiques (ou ALD pour « *Atomic Layer Déposition* ») sur la couche de nitrure de titane 102.

On précise ici que le terme « dépôt d'une première couche sur une deuxième couche » signifie que la première couche est déposée directement sur la deuxième couche. En d'autres termes, suite au dépôt, la première couche est en contact direct avec la deuxième couche. On dit aussi que la première couche recouvre la deuxième couche, ou même que la première couche recouvre directement la deuxième couche. Le dépôt d'une première couche sur une deuxième couche implique l'absence d'une couche intermédiaire entre la première et la deuxième couches.

L'incorporation de la couche de nitrure de titane 102 entre la couche de métal 101 et la couche d'oxyde d'aluminium (ou alumine) 103 autorise une reprise de contact électrique à travers la couche d'oxyde d'aluminium 103, notamment à l'aide d'une pointe ou par des techniques usuelles de câblage par fil (« *wire bonding* » en anglais).

Pour mémoire, on rappelle que la technique de dépôt ALD est un cas particulier de dépôt CVD, qui consiste à exposer une surface successivement à différents précurseurs chimiques pendant des intervalles de temps prédéterminés (cycles de dépôt) afin d'obtenir des couches ultra-minces. Un dépôt ALD met en oeuvre au moins un cycle de dépôt de monocouche ultra-mince sur une surface. Au cours de chaque cycle, des précurseurs chimiques réagissent de façon à recouvrir *in fine* la surface par une couche qui, selon les applications, peut être ultra-mince (typiquement la monocouche, ou de 1 nm à 30 nm d'épaisseur) ou plus épaisse (par exemple jusqu'à 100 nm, ou entre 25 nm et 50 nm). Le nombre de cycles mis en oeuvre permet d'obtenir une épaisseur désirée sur la surface.

Une application particulièrement avantageuse de cette propriété concerne le domaine de l'encapsulation de composants électroniques, en particulier opto-électroniques, notamment lorsque ces composants comportent une couche active organique.

Grâce à un choix judicieux de couche d'encapsulation (oxyde d'aluminium déposé par dépôt ALD), et en intercalant une couche de nitrure de titane entre la piste de contact électrique en métal et la couche d'encapsulation, on autorise un contact électrique sur la piste de contact électrique et au travers de la couche d'encapsulation. En particulier, un courant électrique peut traverser la couche d'encapsulation pour atteindre la piste de contact électrique.

On obtient ainsi une encapsulation permettant de connecter électriquement les composants encapsulés, et ne présentant qu'un faible nombre d'étapes. Le procédé selon l'invention est très simple à mettre en oeuvre. En particulier, aucune étape de masquage, ou de photolithographie et gravure, ou encore d'ablation partielle n'est nécessaire. En outre, la couche d'encapsulation n'étant pas ouverte au niveau des pistes de contact électrique, le dispositif électronique selon l'invention présente une excellente stabilité mécanique.

On pourra également remarquer que dans de nombreux cas, le procédé usuel d'encapsulation recouvre les pistes de contact électriques par une couche d'oxyde d'aluminium. Ce sera par exemple le cas si l'on met en oeuvre un procédé d'encapsulation appelé SHB (pour Super Haute Barrière) décrit par exemple dans la demande de brevet FR2958795. Selon ce procédé, on protège efficacement un composant à l'aide d'un empilement tricouche fait d'une couche d'oxyde, d'une couche de polymère organique et d'une couche externe d'oxyde d'aluminium déposée par dépôt ALD. Dans de tels cas, la mise en oeuvre du procédé selon l'invention ne nécessitera que l'ajout d'une couche intermédiaire de nitrure de titane.

Un autre avantage de l'invention est que la couche d'oxyde d'aluminium au-dessus des pistes de contact électrique permet de les protéger contre des agressions environnementales (notamment en empêchant la corrosion), ce qui augmente la durée de vie du dispositif électronique.

Dans la suite, on décrira plusieurs modes de réalisation de parties d'un dispositif électronique selon l'invention. La description des dispositifs électroniques permettra également d'illustrer le procédé selon l'invention.

La figure 2 illustre un premier mode de réalisation d'une partie d'un dispositif électronique 1 selon l'invention.

Selon ce mode de réalisation, un composant 2 électronique ou opto-électronique, réalisé sur un substrat 3, est encapsulé par un capot d'encapsulation constitué d'une unique couche d'encapsulation 4.

La couche d'encapsulation 4 est formée par une couche mince d'oxyde d'aluminium déposée par dépôt ALD.

On pourra reconnaître en pratique, que l'oxyde d'aluminium a été déposé par ALD, car il présente alors généralement une microstructure dense et non colonnaire. Cette microstructure peut être observée par microscopie électronique en transmission (TEM en anglais pour « *Transmission Electron Microscopy* »), couplée à une analyse dispersive en énergie (EDX en anglais pour « *Energy Dispersive X-ray spectrometry* »). Si l'on compare la microstructure d'un dépôt d'Al₂0₃ par ALD et par PVD, selon une vue en coupe, on observe dans le premier cas une structure homogène alors que dans le deuxième cas l'image présente des tâches ovales partiellement superposées les unes sur les autres.

Le composant 2 présente deux pistes de contact électrique constituées chacune d'une couche de métal 101 sur le substrat 3, au contact direct du composant 2. Ces pistes de contact électrique sont dédiées à la connexion électrique du composant 2 et permettent notamment de le raccorder à une électronique d'adressage située à l'extérieur du capot d'encapsulation. Lors du dépôt de la couche d'encapsulation sur et autour du composant 2, selon l'art antérieur, ces pistes de contact électriques se trouvent recouvertes par de l'oxyde d'aluminium.

Selon l'invention, une couche de nitrure de titane 102 est déposée directement sur la couche de métal 101 formant la piste de contact électrique, avant que le composant 2, ainsi que l'ensemble formé par les pistes de contact électrique et les couches de nitrure de titane respectives, ne soient recouverts par la couche d'encapsulation 4.

La partie de la couche d'encapsulation située au-dessus de la piste de contact électrique en métal forme une couche d'oxyde d'aluminium 103 telle que présentée en référence à la figure 1. On réalise ainsi, dans une zone 5 du dispositif électronique 1, un empilement 10 tel que décrit en référence à la figure 1.

Le dispositif électronique 1 selon l'invention permet ainsi une reprise de contact électrique au travers de la couche d'oxyde d'aluminium. On réalise la connexion électrique du composant 2, via les pistes de contact électrique en métal 101, directement après le dépôt de la couche d'encapsulation 4. La connexion électrique du composant 2 peut par exemple mettre en oeuvre un câblage par fil dit « *wire bonding* ». Un fil de contact (non représenté), par exemple en aluminium, est déposé et soudé sur le dessus de la couche d'encapsulation 4, au-dessus de la couche de métal 101. Le procédé selon l'invention comprend cette étape de câblage d'un élément de contact électrique, directement sur le dessus de la couche d'encapsulation.

Le dépôt de la couche de nitrure de titane 102 est typiquement réalisé par dépôt physique en phase vapeur, dit dépôt PVD (pour l'anglais « *Physical Vapor Deposition* »). Un dépôt PVD permet de déposer une couche mince sur une surface, par condensation d'un matériau en phase gazeuse sur ladite surface.

Un avantage de recourir à un tel type de dépôt est que le dépôt de couche peut être plus facilement localisé uniquement au niveau de la piste de contact électrique, par l'emploi de masque dits pochoirs (« *shadow masks* » en langue anglaise).

Dans certains cas, on réalisera également les pistes de contact électrique, par dépôt PVD d'une couche de métal 101 sur un substrat tel que de l'oxyde d'indium dopé à l'étain (ITO).

L'épaisseur 120 de la couche d'encapsulation 4 est typiquement comprise entre 20 nm et 200 nm, par exemple 50 nm ou 100 nm. Préférentiellement, cette épaisseur est comprise entre 25 nm et 120 nm.

De telles épaisseurs permettent de réaliser des couches d'encapsulation offrant une excellente étanchéité et une durée de vie élevée. On a constaté que de telles épaisseurs permettaient toujours la reprise du contact électrique au travers de la couche d'encapsulation.

L'épaisseur 121 de la couche de nitrure de titane 102 est comprise entre 5 nm et 250 nm, par exemple 7 nm, 25 nm, 50 nm ou 100 nm. Préférentiellement, cette épaisseur est comprise entre 25 nm et 120 nm.

On voit donc que même de faibles épaisseurs de nitrure de titane permettent d'obtenir l'effet recherché de conduction électrique.

La couche de métal 101 est par exemple en alliage d'aluminium et cuivre AlCu. L'alliage présente typiquement un taux de cuivre compris entre 1% et 2 %.

On pourra également envisager d'autres métaux, par exemple de l'aluminium, du chrome ou du cuivre.

On a réalisé en laboratoire plusieurs séries d'expériences, montrant qu'un empilement 10 selon l'invention permet d'établir un contact électrique entre une pointe de test et la couche de métal 101 formant une piste de contact électrique. Ce contact électrique peut être réalisé à l'aide d'une pointe dite douce, c'est-à-dire qui ne pénètre pas à l'intérieur de la couche d'oxyde d'aluminium. Une pointe douce est par exemple en alliage béryllium cuivre.

On a par exemple réalisé les empilements suivants :
- 200 nm d'aluminium déposé par évaporation par faisceau d'électrons ;
- 100 nm de nitrure de titane déposé par pulvérisation magnétron à température ambiante ;
- 25 nm d'oxyde d'aluminium déposé par ALD à une température de 85°C, et dans une variante, à 250°C.

De tels empilements offrent une résistance de contact négligeable et permettent un contact électrique entre une pointe douce et la couche d'aluminium.

On a également réalisé l'empilement suivant :
- chrome déposé par évaporation par faisceau d'électrons ;
- nitrure de titane déposé par évaporation par faisceau d'électrons ;
- 25 nm d'oxyde d'aluminium déposé par ALD à une température de 85°C.

Un tel empilement offre une résistance de contact de 13 Ω et permet un contact électrique entre une pointe douce et la couche de chrome.

On a également réalisé l'empilement suivant :
- 200 nm d'alliage AlCu déposé par pulvérisation magnétron sur 5 nm de nitrure de titane ;
- 7 nm de nitrure de titane déposé par pulvérisation magnétron ;
- 25 nm ou 50 nm d'oxyde d'aluminium déposé par ALD à une température de 85°C.

Un tel empilement offre une résistance de contact négligeable et permet un contact électrique entre une pointe douce et la couche d'alliage AlCu.

On a également réalisé l'empilement suivant :
- 100 nm de chrome déposé par évaporation par faisceau d'électrons ;
- 30 nm de nitrure de titane déposé par pulvérisation magnétron ;
- 25 nm d'oxyde d'aluminium déposé par ALD à une température de 85°C.

Un tel empilement offre une résistance de contact de 29 Ω et permet un contact électrique entre une pointe douce et la couche de chrome.

Si l'on remplace la couche d'oxyde d'aluminium par un autre oxyde tel qu'un oxyde de silicium SiOx, on perd le contact électrique à l'aide d'une pointe douce. Il en est de même si l'on supprime la couche intermédiaire de nitrure de titane.

Le dépôt par ALD est réalisé par exemple à une température inférieure à 100°C, notamment inférieure à 85°C. Cependant, on peut envisager d'autres gammes de températures. On voit notamment qu'un dépôt à 250°C permet toujours d'obtenir l'effet recherché.

Le composant 2 est un dispositif sensible à l'atmosphère. Il peut s'agir d'au moins un composant parmi :
- un dispositif organique tel qu'un transistor organique OTFT (pour « *Organic Thin-Film Transistor* »), un dispositif OPV (pour « *organic photovoltaic* »), ou une OLED, construit sur un support souple ;
- un micro-afficheur formé par un afficheur organique (en particulier une OLED) construit sur un circuit CMOS (pour « *Complementary Metal Oxide Semiconductor* ») ;
- une cellule solaire inorganique, par exemple à base d'oxyde de zinc (ZnO) ;
- un dispositif micro-électronique tel qu'un transistor utilisant des oxydes transparents sensibles à l'environnement (transistor TFT, pour l'anglais « *Thin-Film Transistor* », comprenant de l'INZO (pour « *Indium Gallium Zinc Oxide* »));
- un circuit imprimé PCB (pour « *Printed Circuit Board* »).

Il s'agit plus particulièrement de composants pouvant nécessiter une protection par procédé SHB, c'est-à-dire pour lesquels on met déjà en oeuvre une encapsulation à l'aide d'une couche d'oxyde d'aluminium déposée par ALD.

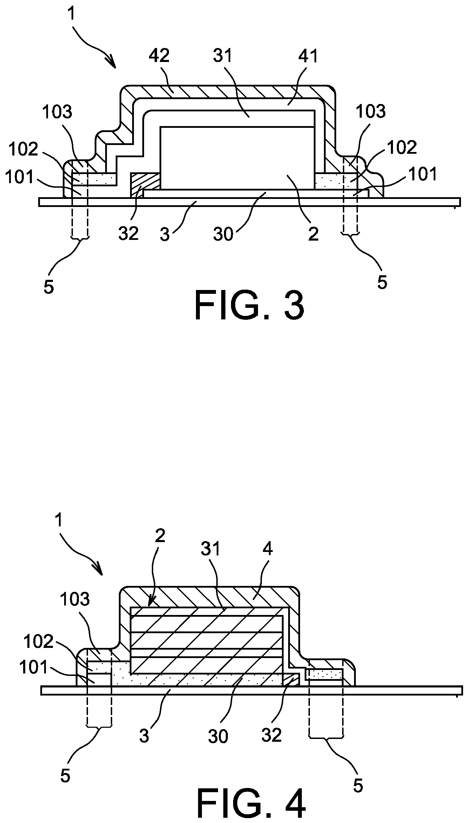

On va maintenant décrire, en référence à la figure 3, un deuxième mode de réalisation d'une partie d'un dispositif électronique 1 selon l'invention. La figure 3 ne sera décrite que pour ses différences relativement à la figure 2.

A la figure 3, chaque piste de contact électrique 101 est formée par un bord d'une couche métallique appartenant au composant 2. En particulier, le composant 2 est formé par un empilement de couches dont une première couche métallique 30 formant anode et une deuxième couche métallique 31 formant cathode, un bord de la première couche métallique formant une première piste de contact électrique et un bord de la deuxième couche métallique formant une deuxième piste de contact électrique.

La première couche métallique 30 forme une couche inférieure du composant 2, côté substrat 3. La deuxième couche métallique 31 forme une couche supérieure du composant 2, du côté opposé au substrat 3.

Dans le mode de réalisation de la figure 3, un isolant 32 permet d'isoler électriquement les couches métalliques 30 et 31.

Le composant 2 est recouvert par un capot d'encapsulation comprenant plusieurs couches 41, 42. La couche d'encapsulation la plus externe (du côté du capot opposé au composant 2) est une couche d'oxyde d'aluminium déposée par dépôt ALD. Cette dernière couche 42 forme la couche d'encapsulation selon l'invention. Seule la couche d'encapsulation 42 recouvre l'ensemble formé par les pistes de contact électrique, elle-même recouverte uniquement d'une couche de nitrure de titane 102 respective. On pourra imaginer de nombreuses variantes dans lesquelles le capot d'encapsulation est constitué d'un empilement de plusieurs couches. Dans tous les cas, on s'assurera que seul l'empilement nitrure de titane et oxyde d'aluminium recouvre les pistes de contact.

On va maintenant décrire, en référence à la figure 4, un troisième mode de réalisation d'une partie d'un dispositif électronique 1 selon l'invention. La figure 4 ne sera décrite que pour ses différences relativement à la figure 3.

Dans ce mode de réalisation, le capot d'encapsulation est constitué de la seule couche d'oxyde d'aluminium déposé par dépôt ALD, et formant la couche d'encapsulation 4 selon l'invention.

Le composant 2 est représenté hachuré entre le substrat 3 et la couche d'encapsulation 4.

Le composant 2 est réalisé par dépôts successifs de couches minces. L'une des couches minces constituant le composant 2 est une couche de nitrure de titane.

Sur une des pistes de contact électrique, la couche de nitrure de titane 102 est réalisée simplement en prolongeant la couche de nitrure de titane faisant partie du composant 2.

Dans l'exemple particulier représenté à la figure 4, cette couche de nitrure de titane forme l'anode 30 du composant 2, qui est alors prolongée jusque sur une piste électrique en métal.

La couche de nitrure de titane déposée sur cette piste de contact électrique est donc simplement le prolongement de l'une des couches constituant le composant 2. Ce mode de réalisation est particulièrement avantageux, puisqu'il combine une étape nécessaire à la fabrication du composant, avec une étape spécifique à la mise en oeuvre de la présente invention. Aucune étape supplémentaire n'est mise en oeuvre, puisqu'il suffit simplement d'adapter l'étendue de dépôt d'une des couches constituant le composant.

Selon une variante non représentée, la couche de nitrure de titane forme la cathode du composant 2, qui est alors prolongée jusque sur une piste électrique en métal.

On pourra également envisager le cas où la couche de nitrure de titane est une couche intermédiaire du composant 2.

Dans ces deux variantes, la couche de nitrure de titane est déposée sur au moins une partie de la piste de contact électrique et sur une couche intermédiaire du composant.

Des composants courants tels que des OLED utilisées notamment pour la réalisation de micro-afficheurs sur circuit CMOS présentent généralement une couche de nitrure de titane. Un empilement AlCu/TiN (alliage aluminium cuivre puis nitrure de titane) est également courant dans le domaine des semi-conducteurs.

L'invention n'est pas limitée aux modes de réalisation décrits. On pourra notamment envisager de nombreuses combinaisons des modes de réalisation décrits. On pourra également envisager d'autres exemples d'épaisseurs de couches, d'autres exemples de métaux formant la couche de métal, d'autres températures de dépôt ALD, d'autres réalisations de capot d'encapsulation. Dans tous les cas, on s'assurera que seul l'empilement nitrure de titane et oxyde d'aluminium recouvre les pistes de contact.

## Revendications

1. Procédé d'encapsulation d'au moins un composant électronique (2), ledit composant (2) étant relié à au moins une piste de contact électrique constituée d'une couche de métal (101), le procédé comprenant une étape de dépôt d'une couche d'encapsulation (4; 42) en oxyde d'aluminium par dépôt de couches minces atomiques, **caractérisé en ce que** :
- le procédé comprend en outre une étape de dépôt d'une couche de nitrure de titane (102) directement sur au moins une partie de la piste de contact électrique (101) ;
- le dépôt de la couche d'encapsulation est réalisé de façon à ce que ladite couche d'encapsulation (4; 42) recouvre directement la couche de nitrure de titane (102), dans une zone située au-dessus de la piste de contact électrique (101) ; et
- le procédé comprend en outre une étape de reprise de contact électrique avec l'au moins une partie de la piste de contact électrique, à l'aide d'une pointe ou un fil de contact déposé sur le dessus de la couche d'encapsulation (4 ; 42) et au-dessus de l'au moins une partie de la piste de contact électrique (101).

2. Procédé selon la revendication 1, dans lequel le dépôt de la couche de nitrure de titane (102) sur au moins une partie de la piste de contact électrique (101) est réalisé par dépôt physique en phase vapeur.

3. Procédé selon la revendication 1 ou 2, dans lequel le dépôt de la couche de nitrure de titane (102) sur au moins une partie de la piste de contact électrique (101) est réalisé au cours d'une étape de fabrication du composant (2), le composant (2) étant fabriqué par dépôts successifs de couches dont l'une au moins est une couche de nitrure de titane.

4. Dispositif électronique (1) comprenant :
- au moins un composant électronique (2) ;
- une couche d'encapsulation (4 ; 42) en oxyde d'aluminium, déposée par dépôt de couches minces atomiques, recouvrant le composant (2) ; et
- au moins une piste de contact électrique reliée au composant (2) et constituée d'une couche de métal (101) ;
**caractérisé en ce que** :
- au moins une partie de la piste de contact électrique (101) est recouverte directement d'une couche de nitrure de titane (102), elle-même recouverte directement de ladite couche d'encapsulation (4; 42) dans toute une zone située au-dessus de la piste de contact électrique (101) ; et
- le dispositif électronique (1) comprend en outre un élément de contact électrique câblé sur le dessus de la couche d'encapsulation (4; 42) et au-dessus de l'au moins une partie de la piste de contact électrique (101), et agencé pour amener un courant jusqu'à la piste de contact électrique (101).

5. Dispositif (1) selon la revendication 4, dans lequel la couche d'encapsulation (4 ; 42) forme une surface externe du dispositif (1).

6. Dispositif (1) selon la revendication 4 ou 5, dans lequel la couche de métal (101) est une couche d'un alliage aluminium et cuivre.

7. Dispositif (1) selon la revendication 4 ou 5, dans lequel la couche de métal (101) est une couche de cuivre ou une couche d'aluminium ou une couche de chrome.

8. Dispositif (1) selon l'une quelconque des revendications 4 à 7, dans lequel la couche d'encapsulation (4 ; 42) présente une épaisseur comprise entre 20 nm et 200 nm.

9. Dispositif (1) selon l'une quelconque des revendications 4 à 8, dans lequel la couche de nitrure de titane (102) présente une épaisseur comprise entre 5 nm et 250 nm.

10. Dispositif (1) selon l'une quelconque des revendications 4 à 9, dans lequel le composant (2) est une cellule solaire inorganique, une OLED, un OPV, ou un composant micro-électronique tel qu'un transistor.

## Patentansprüche

1. Verfahren zum Einkapseln zumindest einer elektronischen Komponente (2), wobei die Komponente (2) mit zumindest einer elektrischen Kontaktbahn verbunden ist, die aus einer Metallschicht (101) besteht, wobei das Verfahren einen Schritt des Abscheidens einer Einkapselungsschicht (4; 42) aus Aluminiumoxid durch Abschneiden von atomaren Dünnschichten umfasst, **dadurch gekennzeichnet, dass**:
- das Verfahren ferner einen Schritt des Abscheidens einer Titannitridschicht (102) direkt auf zumindest einen Teil der elektrischen Kontaktbahn (101) umfasst;
- das Abscheiden der Einkapselungsschicht so erfolgt, dass die Einkapselungsschicht (4; 42) die Titannitridschicht (102) in einem Bereich direkt überdeckt, der oberhalb der elektrischen Kontaktbahn (101) liegt; und
- das Verfahren ferner einen Schritt der Wiederaufnahme des elektrischen Kontakts mit dem zumindest einen Teil der elektrischen Kontaktbahn mit Hilfe eines Kontaktstifts oder -drahts umfasst, der auf die Oberseite der Einkapselungsschicht (4; 42) und oberhalb des zumindest einen Teils der elektrischen Kontaktbahn (101) aufgebracht wird.

2. Verfahren nach Anspruch 1, wobei
das Abscheiden der Titannitridschicht (102) auf zumindest einen Teil der elektrischen Kontaktbahn (101) durch physikalische Dampfphasenabscheidung erfolgt.

3. Verfahren nach Anspruch 1 oder 2, wobei
das Abscheiden der Titannitridschicht (102) auf zumindest einen Teil der elektrischen Kontaktbahn (101) bei einem Schritt des Herstellens der Komponente (2) erfolgt, wobei die Komponente (2) durch aufeinanderfolgende Abscheidungen von Schichten hergestellt wird, von denen zumindest eine eine Titannitridschicht ist.

4. Elektronische Vorrichtung (1), enthaltend:
- zumindest eine elektronische Komponente (2),
- eine Einkapselungsschicht (4; 42) aus Aluminiumoxid, die durch Abscheiden von atomaren Dünnschichten abgeschieden wird und die die Komponente (2) überdeckt; und
- zumindest eine elektrische Kontaktbahn, die mit der Komponente (2) verbunden ist und aus einer Metallschicht (101) besteht;
**dadurch gekennzeichnet, dass**
- zumindest ein Teil der elektrischen Kontaktbahn (101) direkt mit einer Titannitridschicht (102) überdeckt ist, die ihrerseits direkt mit der Einkapselungsschicht (4; 42) in einem ganzen Bereich überdeckt ist, der oberhalb der elektrischen Kontaktbahn (101) liegt; und
- die elektronische Vorrichtung (1) ferner einen elektrisches Kontaktelement enthält, das an der Oberseite der Einkapselungsschicht (4; 42) und oberhalb des zumindest einen Teils der elektrischen Kontaktbahn (101) angeschlossen ist und dazu vorgesehen ist, der elektrischen Kontaktbahn (101) einen Strom zuzuführen.

5. Vorrichtung (1) nach Anspruch 4, wobei
die Einkapselungsschicht (4; 42) eine Außenfläche der Vorrichtung (1) bildet.

6. Vorrichtung (1) nach Anspruch 4 oder 5, wobei
die Metallschicht (101) eine Schicht aus einer Legierung aus Aluminium und Kupfer ist.

7. Vorrichtung (1) nach Anspruch 4 oder 5, wobei
die Metallschicht (101) eine Kupferschicht oder eine Aluminiumschicht oder eine Chromschicht ist.

8. Vorrichtung (1) nach einem der Ansprüche 4 bis 7, wobei
die Einkapselungsschicht (4; 42) eine Dicke zwischen 20 nm und 200 nm aufweist.

9. Vorrichtung (1) nach einem der Ansprüche 4 bis 8, wobei
die Titannitridschicht (102) eine Dicke zwischen 5 nm und 250 nm aufweist.

10. Vorrichtung (1) nach einem der Ansprüche 4 bis 9, wobei
die Komponente (2) eine anorganische Solarzelle, eine OLED, ein OPV oder eine mikroelektronische Komponente, wie ein Transistor, ist.

## Claims

1. Encapsulation process for at least one electronic component (2), said component (2) being connected to at least one electrical contact track composed of a metal layer (101), the process comprising a step to deposit an aluminium oxide encapsulation layer (4 ; 42) by atomic layer deposition, **characterised in that**:
- the process also comprises a step to deposit a titanium nitride layer (102) directly on at least part of the electrical contact track (101);
- the encapsulation layer is deposited such that said encapsulation layer (4 ; 42) directly covers the titanium nitride layer (102), in an area located above the electrical contact track (101); and
- the process further comprises a step to establish electrical contact with the at least part of the electrical contact track, using a contact point or wire deposited on top of the encapsulation layer (4; 42) and above the at least part of the electrical contact track.

2. Process according to claim 1, wherein the titanium nitride layer (102) is deposited on at least part of the electrical contact track (101) by physical vapor deposition.

3. Process according to claim 1 or 2, wherein the titanium nitride layer (102) is deposited on at least part of the electrical contact track (101) during a manufacturing step of the component (2), the component (2) being manufactured by successive layer depositions of which at least one is a titanium nitride layer.

4. Electronic device (1) comprising:
- at least one electronic component (2);
- an aluminium oxide encapsulation layer (4; 42) deposited by atomic layer deposition, covering the component (2); and
- at least one electrical contact track connected to the component (2) and composed of a metal layer (101);
**characterised in that**:
- at least part of the electrical contact track (101) is directly covered with a layer of titanium nitride (102), itself directly covered with said encapsulation layer (4; 42) in a whole area located above the electrical contact track (101); and
- the electronic device (1) further comprises an electrical contact element wired on top of the encapsulation layer (4 ; 42) and above the at least part of the electrical contact track, and arranged to carry a current to the electrical contact track (101).

5. Device (1) according to claim 4, wherein the encapsulation layer (4; 42) forms an external surface of the device (1).

6. Device (1) according to claim 4 or 5, wherein the metal layer (101) is an aluminium and copper alloy layer.

7. Device (1) according to claim 4 or 5, wherein the metal layer (101) is a copper layer or an aluminium layer or a chromium layer.

8. Device (1) according to any one of claims 4 to 7, wherein the encapsulation layer (4 ; 42) is between 20 nm and 200 nm thick.

9. Device (1) according to any one of claims 4 to 8, wherein the titanium nitride layer (102) is between 5 nm and 250 nm thick.

10. Device (1) according to any one of claims 4 to 9, wherein the component (2) is an inorganic solar cell, an OLED, an OPV, or a micro-electronic components such as a transistor.
